# EUROPEAN PATENT SPECIFICATION

(11) **EP 4 380 183 B1**
(45) Date of publication and mention of the grant of the patent: **15.04.2026**
(21) Application number: 23198792.6
(22) Date of filing: 21.09.2023
(51) Int. Cl.: H04R 1/08, H04R 19/00, H04R 19/04, H04R 31/00, B81B 7/00, B81C 99/00, H04R 1/44

(54) **METHOD FOR PRODUCING A MECHANICALLY COMPLIANT NANOFIBROUS ENVIRONMENTAL BARRIER MEMBRANE**
VERFAHREN ZUR HERSTELLUNG EINER MECHANISCH KONFORMEN NANOFASERIGEN UMWELTBARRIEREMEMBRAN
PROCÉDÉ DE PRODUCTION D'UNE MEMBRANE BARRIÈRE ENVIRONNEMENTALE NANOFIBREUSE MÉCANIQUEMENT SOUPLE

(30) Priority: 01.12.2022 EP 22210912; 01.12.2022 EP 22210899
(43) Date of publication of application: 05.06.2024
(73) Proprietor: Infineon Technologies AG, 85579 Neubiberg (DE)
(72) Inventor: ANZINGER, Sebastian, 83714 Miesbach (DE); WASISTO, Hutomo Suryo, 81541 München (DE); SCHWÄGERL, Sebastian, 93413 Cham (DE)
(74) Representative: Fischer, Florian

(56) References cited:
- WO-A1-2021/025378
- AMINI GOLCHEHR ET AL: "Improving adhesion of electrospun nanofiber mats to supporting substrate by using adhesive bonding", vol. 86, 23 August 2018 (2018-08-23), AMSTERDAM, NL, pages 40 - 44, XP093136296, ISSN: 0143-7496, Retrieved from the Internet <URL:https://pdf.sciencedirectassets.com/271565/1-s2.0-S0143749618X00050/1-s2.0-S0143749618301969/main.pdf?X-Amz-Security-Token=IQoJb3JpZ2luX2VjEBoaCXVzLWVhc3QtMSJIMEYCIQDSIXZfWyFKBXcCUfhCvxCL/QYSc+CShc4VZbB+Hi1UvAIhANzlIQpmw7yi0GUQYeFr+wKw3J+Axr6ydj3Gm/hWYXCdKrMFCBMQBRoMMDU5MDAzNTQ2ODY1Igw+pDm/QCZvywmUa> [retrieved on 20240229], DOI: 10.1016/j.ijadhadh.2018.08.005

## Description

This application claims priority from European patent application EP 22 210 912.6 and from European patent application No. EP 22 210 899.5.

### GENERAL DESCRIPTION

Embodiments of the present disclosure relate to a micromechanical environmental barrier membrane for providing a protection for Micro Electro Mechanical System (MEMS)-based sound and/or pressure devices against ingress of environmental solid, gaseous and/or moist particles. Further embodiments relate to a manufacturing method thereof.

### TECHNICAL BACKGROUND

Next generation silicon microelectromechanical system (MEMS)-based microphones, and potentially also other sensors, are expected to have environmental barriers (EBs) in their package construction to be able to withstand harsh environmental conditions, including impacting solid objects (e.g., dust particles and hairs) and high water ingression. Today it is also rather common that environmental barrier structures are integrated on application system level, e.g., somewhere in the sound channel.

Environmental barrier structures should affect the function of a MEMS device as little as possible, i.e., the provision of an environmental barrier structure should not negatively affect the acoustic performance of the MEMS device (e.g., signal-to-noise (SNR) ratio). Thus, when designing environmental barrier structures, it is desirable to provide a high mechanical compliance / flexibility of the environmental barrier structure while at the same time providing a high air flow through the environmental barrier structure. In other words, an environmental barrier structure should comprise a low acoustic / airflow resistance and a high mechanical compliance at the same time. However, this is a trade-off because a low acoustical resistance typically means an increased airflow through the material (larger pores or larger open area) and therefore a reduced protection from dust and water ingress. On the other hand, a higher acoustic resistance typically means a reduced airflow through the material (due to less perforation or open area) and therefore an improved protection from dust and water ingress on the cost of SNR.

Some environmental barrier structures may comprise a highly compliant / flexible environmental barrier membrane being made from expanded polytetrafluoroethylene (ePTFE). The ePTFE membrane may be attached to a carrier frame to support the construction and to enable bonding and mounting of the environmental barrier structure onto a printed circuit board (PCB) inside or outside the package. This environmental barrier structure may be integrated in the package during the backend packaging process or on system level during an assembly process.

WO 2021 / 025 378 A1 suggests providing a waterproof filter being formed of a porous membrane formed through electrospinning. The waterproof filter is formed in the form of a porous film having high elasticity by electrospinning a polymer material to form a polymer material layer on a web. The waterproof filter is directly attached to a bottom side of a PCB covering a sound port provided in the PCB.

Problems of these environmental barrier structures are mainly their high costs related with the individual single-unit production of each environmental barrier structure.

Thus, it would be desirable to provide an environmental barrier structure for MEMS-based acoustic and/or pressure devices, said environmental barrier structure comprising a low acoustic / airflow resistance and a high mechanical compliance at the same time, while keeping manufacturing costs at a moderate level.

These goals can be achieved with a method for producing a microstructured air-permeable environmental barrier membrane in accordance with the herein described innovative concept, as well as with an environmental barrier chip comprising a microstructured air-permeable environmental barrier membrane being manufactured by said method.

According to a first aspect, a method for producing an environmental barrier chip comprising a microstructured air-permeable environmental barrier membrane according to claim 1 comprises a step of providing a substrate, and structuring a through hole into the substrate, the through hole extending fully through the substrate between two opposite surfaces of the substrate. The method further comprises a step of leaving the through hole uncovered and depositing nanofibers onto at least one of the two opposite substrate surfaces by applying at least one of an electrospinning or blowspinning method, such that the spun nanofibers combine to a network of nanofibers that forms a free-standing and mechanically compliant nanofibrous membrane covering the previously uncovered through hole of the environmental barrier chip.

According to a second alternative aspect, an alternative method for producing an environmental barrier chip comprising a microstructured air-permeable environmental barrier membrane according to claim 2 comprises a step of providing a substrate having a first substrate surface and an opposite second substrate surface, and depositing a sacrificial layer onto at least one of the two opposite substrate surfaces. The method further comprises a step of structuring a through hole into the substrate, the through hole extending fully through the substrate between two opposite substrate surfaces, wherein the sacrificial layer remains and covers the through hole. A further step comprises depositing nanofibers onto the sacrificial layer by applying at least one of electrospinning or blowspinning methods, such that the spun nanofibers combine to a network of nanofibers that forms a nanofibrous membrane. A further method step includes removing the sacrificial layer for releasing the nanofibrous membrane, wherein the released nanofibrous membrane forms a free-standing and mechanically compliant nanofibrous membrane that covers the through hole.

Furthermore, according to a third aspect, an environmental barrier chip with an air-permeable environmental barrier membrane is provided, the environmental barrier chip comprising a substrate comprising a through hole extending fully through the substrate between two opposite substrate surfaces. A free-standing and mechanically compliant nanofibrous membrane is arranged on at least one of the two opposite surfaces of the substrate, such that the nanofibrous membrane covers the through hole. According to the herein described innovative concept, the nanofibrous membrane is formed by a network of spun nanofibers being arranged on at least one of the two opposite surfaces of the substrate.

In the following, embodiments of the present disclosure are described in more detail with reference to the figures, in which
- Fig. 1A: shows a side elevational view of an environmental barrier chip comprising a free-standing mechanically compliant environmental barrier membrane according to an embodiment,
- Fig. 1B: shows a top view onto an environmental barrier chip comprising a free-standing mechanically compliant environmental barrier membrane according to an embodiment,
- Fig. 1C: shows a perspective view of an environmental barrier chip comprising a free-standing mechanically compliant environmental barrier membrane according to an embodiment,
- Fig. 2A: shows an exploded perspective view of an environmental barrier chip comprising a free-standing mechanically compliant environmental barrier membrane according to an embodiment,
- Fig. 2B: shows a side elevational view of an environmental barrier chip comprising a free-standing mechanically compliant environmental barrier membrane according to an embodiment,
- Fig. 3A: shows an exploded perspective view of an environmental barrier chip comprising a free-standing mechanically compliant environmental barrier membrane being manufactured by an alternative method according to an embodiment,
- Fig. 3B: shows a side elevational view of an environmental barrier chip comprising a free-standing mechanically compliant environmental barrier membrane being manufactured by an alternative method according to an embodiment,
- Figs. 4A-4D: show the density distribution of deposited nanofibers during a proceeding application time,
- Figs. 5A-5B: show side elevational views of an environmental barrier chip comprising a free-standing mechanically compliant environmental barrier membrane according to an embodiment,
- Figs. 6A-6D: show a process flow of a first method for manufacturing an environmental barrier chip with a free-standing mechanically compliant environmental barrier membrane according to an embodiment,
- Figs. 7A-7E: show a process flow of an alternative second method for manufacturing an environmental barrier chip with a free-standing mechanically compliant environmental barrier membrane according to an embodiment,
- Fig. 8A: shows an exploded perspective view of an environmental barrier chip comprising a mechanically compliant environmental barrier membrane being supported by an environmental barrier structure that is configured as a mechanically compliant perforated membrane,
- Fig. 8B: shows a top view onto the environmental barrier chip with the environmental barrier structure applied thereon,
- Fig. 8C: shows a top view onto the environmental barrier chip of Figure 8B with an additional nanofibrous environmental barrier membrane,
- Figs. 9A-9B: shows side elevational views of the environmental barrier chip according to Figures 8A-8C with and without a force being applied to the environmental barrier structure, and
- Figs. 10A-10D: show a process flow of a method for manufacturing the environmental barrier chip according to Figures 8A-8C with a mechanically compliant environmental barrier membrane.

### DESCRIPTION OF THE FIGURES

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

The herein described innovative nanofibrous air-permeable environmental barrier membrane, as well as the environmental barrier chip comprising said nanofibrous air-permeable environmental barrier membrane, can be used to protect MEMS devices in general from harmful environmental influences. The nanofibrous air-permeable environmental barrier membrane may be particularly useful to protect MEMS pressure transducers, such as MEMS pressure sensors, MEMS microphones, and MEMS speakers. In the following description of the Figures, MEMS microphones and MEMS speakers are used as non-limiting examples for MEMS devices in general.

Upon designing environmental barrier structures for MEMS devices, such as MEMS microphones or MEMS speakers, it is desired to provide a grid / mesh with a high grid / mesh density in order to improve the environmental protection level (to be able to withstand e.g., water ingression at a certain pressure / depth). Furthermore, it would be desirable to provide rigid meshes for the sake of stability. However, at the same time, good acoustic performance needs to be maintained. Ideally, this may be accomplished with free-standing flexible membranes where acoustic energy can be transferred via membrane oscillations (mechanical compliance).

Accordingly, there is a trade-off between a dense and rigid environmental barrier structure for providing a high protection level with high robustness, and a mechanically compliant / flexible membrane for transferring acoustic energy as lossless as possible.

For example, an ideal membrane may have a compliant / flexible behavior but a low airflow. An ideal mesh, in turn, may have a high airflow but a rigid / stiff structure. However, since real-life devices usually do not comprise an ideal behavior, real-life meshes and membranes may lead to some unavoidable degree of SNR-loss.

The herein described innovative concept combines the positive characteristics of both membranes and meshes by providing a microstructured air-permeable environmental barrier membrane that is made from spun nanofibers which combine to a network of nanofibers that forms a free-standing and mechanically compliant nanofibrous membrane. Examples and embodiments thereof will be described in the following.

For ease of understanding of the innovative mechanically compliant nanofibrous membrane, a brief introduction to mechanical compliance shall be given first. In mechanical engineering, a compliant mechanism is a flexible mechanism that achieves force and motion transmission through elastic body deformation. It gains some or all of its motion from the relative flexibility of its members rather than from rigid-body joints alone. These may be monolithic (single-piece) or jointless structures.

Compliant structures are often created as an alternative to similar mechanisms that use multiple parts. There are two main advantages for using compliant mechanisms. First, a compliant mechanism can usually be fabricated into a single structure, which is a simplification in the number of required parts thereby leading to low manufacturing costs. Second, compliant mechanisms have a better efficiency since they do not suffer from some issues that affect multi-bodied mechanisms, such as backlash or surface wear. Due to the usage of flexible elements, compliant mechanisms can easily store energy to be released at a later time or transformed into other forms of energy.

Accordingly, a mechanically compliant membrane may be subsumed under the above mentioned compliant systems. A mechanically compliant membrane is a flexible membrane that is able to oscillate in response to applied acoustic energy, and which returns back to its initial state when said acoustic energy is not applied anymore.

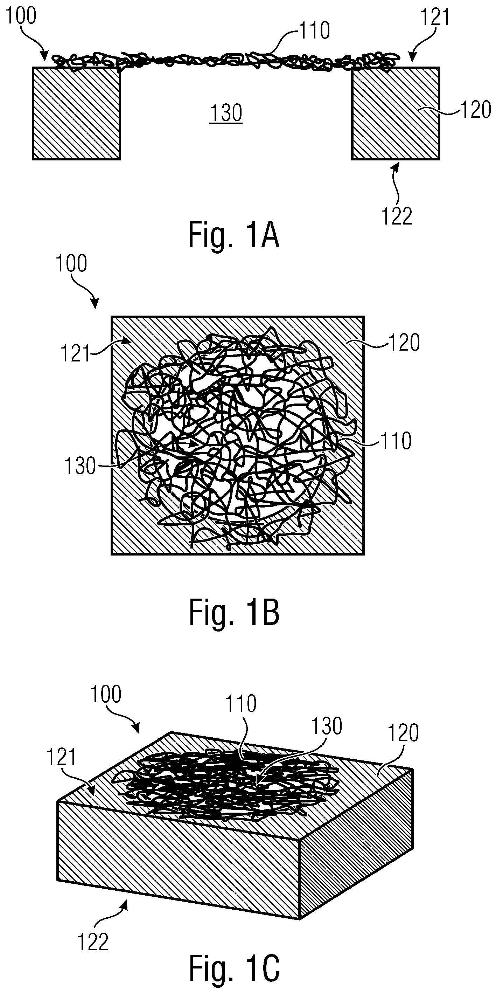

Figures 1A, 1B and 1C show a side elevational view, a top view and a perspective view of a single environmental barrier chip 100 according to an embodiment comprising an air-permeable environmental barrier membrane 110. The environmental barrier chip 100 comprises a substrate 120 having a through hole 130 extending fully through the substrate 120 between two opposite surfaces 121, 122 of the substrate 120. The substrate 120 may comprise, or consist of, a semiconductor material, glass, a polymer or any other suitable material.

The through hole 130 may comprise any kind of geometrical shape, e.g., circular, rectangular, triangular, oval, pentagonal, hexagonal, octagonal. Furthermore, the through hole 130 may extend straight through the substrate 120 or in a bend / curved shape. The through hole 130 may extend vertically through the substrate 120, i.e., orthogonally to the two opposite substrate surfaces 121, 122, or it may extend with any skew angle (different from an orthogonal 90°-angle) between the first and second substrate surfaces 121, 122.

A free-standing and mechanically compliant nanofibrous membrane 110 is arranged on at least one of the two opposite surfaces 121, 122 of the substrate 120, such that the nanofibrous membrane 110 covers the through hole 130. In this non-limiting example, the membrane 110 may be arranged on a first substrate surface 121.

In the embodiments shown in Figures 1A, 1B and 1C the nanofibrous membrane 110 is arranged on exactly one of the two opposite surfaces 121, 122 of the substrate 120. However, it may also be possible that the depicted nanofibrous membrane 110 may be arranged on the opposite substrate surface 122, or that an additional second nanofibrous membrane may be provided, wherein a first nanofibrous membrane 110 may be arranged on the first substrate surface 121 and a second nanofibrous membrane 110 may be arranged on the opposite second substrate surface 122.

According to the herein described innovative concept, the nanofibrous membrane 110 is formed by a network of spun nanofibers being deposited / spun onto at least one of the two opposite surfaces 121, 122 of the substrate 120. After being arranged on the substrate 120, the nanofibrous membrane 110 forms an air-permeable environmental barrier membrane. In other words, the innovative free-standing nanofibrous membrane 110 acts as an air-permeable and mechanically compliant environmental barrier membrane.

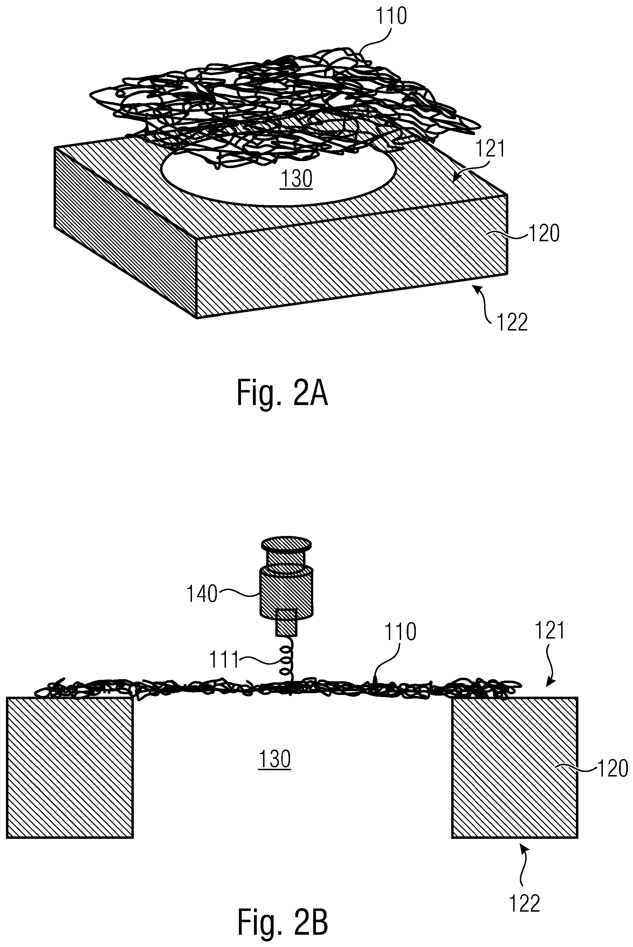

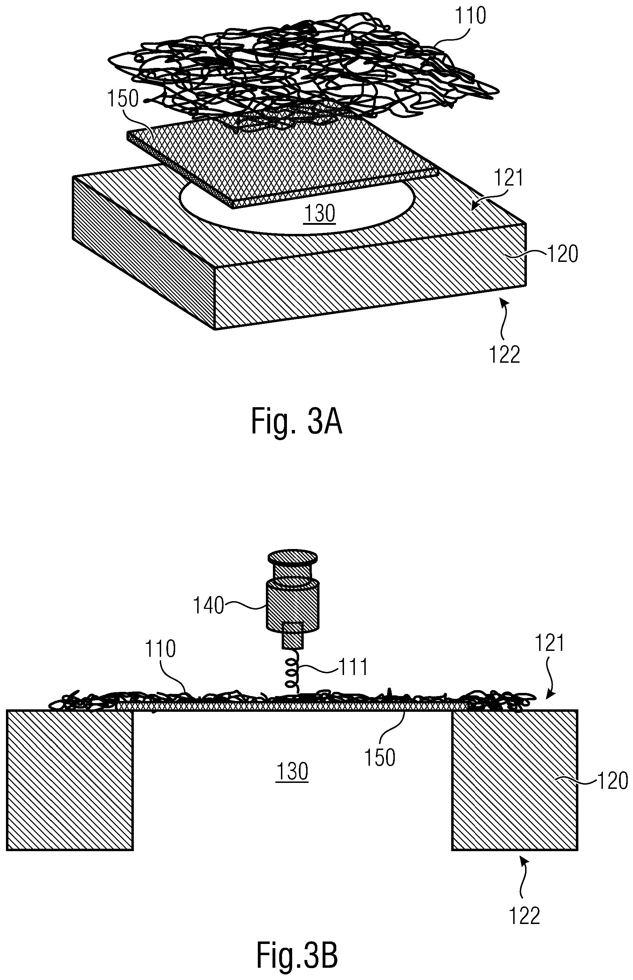

Figures 2A and 2B show a first embodiment of a method for manufacturing / producing the microstructured free-standing air-permeable nanofibrous environmental barrier membrane 110. Figures 3A and 3B show an alternative second method for manufacturing / producing the microstructured free-standing air-permeable nanofibrous environmental barrier membrane 110. Accordingly, two alternative methods for manufacturing the same device 110 are suggested. Thus, two alternative solutions for the same technical problem are described herein.

According to the first alternative, as depicted in Figures 2A and 2B, the method comprises a step of providing a substrate 120 and structuring a through hole 130 into the substrate 120, the through hole 130 extending fully through the substrate 120 between the two opposite substrate surfaces 121, 122. The through hole 130 may be created by etching, e.g., by deep reactive ion etching (DRIE). Optionally, an etch stop layer (not shown) may therefore be deposited onto said one of the two substrate surfaces 121, 122.

According to this first alternative, the through hole 130 is left open or uncovered. Then, one or more single nanofibers 111 are deposited onto said at least one of the two opposite substrate surfaces 121, 122 by applying an electrospinning or blowspinning method. This is schematically symbolized by means of tool 140 in Figure 2B.

In order to obtain an enhanced adhesion of the spun nanofibers 111 at the respective substrate surface 121, 122, an adhesion promotion layer (not shown) may be deposited onto the respective substrate surface 121, 122. The nanofibers 111 may then be deposited / spun onto said adhesion promotion layer.

Of course, upon depositing / spinning the nanofibers 110 onto the respective substrate surface 121, 122 the spun nanofibers 111 may also extend over the through hole 130. The through hole 130 may comprise a size (e.g., a diameter) that is small enough such that the spun nanofibers 111 do not fall into the through hole 130.

The spun nanofibers 111 may then be combined to a network of nanofibers that forms a free-standing and mechanically compliant nanofibrous membrane 110 that covers the through hole 130 which has been intentionally left uncovered before. In this constellation, the nanofibrous membrane 110 acts as a nanofibrous and mechanically compliant air-permeable environmental barrier membrane. In result, an environmental barrier chip 100 being equipped with a free-standing and mechanically compliant nanofibrous membrane 110, as described above with reference to Figures 1A, 1B and 1C can be obtained.

Figures 3A and 3B show a second alternative of a method for producing an environmental barrier chip 100 with a nanofibrous air-permeable and mechanically compliant environmental barrier membrane 110. According to this second alternative, the through hole 130 is not left uncovered. Instead, prior to structuring the through hole 130 into the substrate 120, a temporary sacrificial layer 150 is deposited onto at least one of the two opposite substrate surfaces 121, 122. Then, the through hole 130 is structured into the substrate 120, such that the through hole 130 fully extends through the substrate 120 between the two opposite substrate surfaces 121, 122 with leaving the temporary sacrificial layer 150 on the respective substrate surface 121. In result, the sacrificial layer 150 covers the through hole 130, i.e., the substrate 120 comprises a through hole 130 that is covered by the temporary sacrificial layer 150.

The through hole 130 may be created by etching, e.g., by deep reactive ion etching (DRIE). The through hole 130 may be structured into the substrate 120 starting from the one substrate surface 122 that is opposite to the other substrate surface 121 on which the temporary sacrificial layer 150 is arranged. The through hole 130 may be structured, e.g. etched, until reaching the temporary sacrificial layer 150. In this case, the temporary sacrificial layer 150 may act as a structuring stop layer, e.g., as an etch stop layer. Alternatively, an additional etch stop layer (not shown) may be deposited between the temporary sacrificial layer 150 and the respective substrate surface 121.

In a next step, one or more single nanofibers 111 may be deposited onto the temporary sacrificial layer 150 by applying an electrospinning or blowspinning method. Again, this is schematically symbolized by means of tool 140 in Figure 3B. The spun nanofibers 111 combine to a network of nanofibers that forms a nanofibrous membrane 110. At this stage, the nanofibrous membrane 110 is supported by the temporary sacrificial layer 150.

In order to obtain an enhanced adhesion of the spun nanofibers 111 at the temporary sacrificial layer 150, an adhesion promotion layer (not shown) may be deposited onto the temporary sacrificial layer 150. The nanofibers 111 may then be deposited / spun onto said adhesion promotion layer.

In a next step, the temporary sacrificial layer 150 is removed in order to release the nanofibrous membrane 110, after which the released nanofibrous membrane 110 forms a free-standing and mechanically compliant nanofibrous membrane 110 covering the through hole 130. In this constellation, the nanofibrous membrane 110 acts as a nanofibrous and mechanically compliant air-permeable environmental barrier membrane.

After removal of the sacrificial layer 150, an environmental barrier chip 100 being equipped with a free-standing and mechanically compliant nanofibrous membrane 110, as described above with reference to Figures 1A, 1B and 1C can be obtained. As will be explained below, the sacrificial layer 150 may be removed with different alternative methods.

According to a first alternative, the step of removing the sacrificial layer 150 may be performed by applying a chemical wet etching process. In this case, the sacrificial layer 150 may be a silicon oxide layer. For example, a silicon oxide may be deposited onto the at least one of the two substrate surfaces 121, 122. This silicon oxide layer 150 may then be removed by means of chemical wet etching, e.g., by applying hydrogen fluoride (HF) or hydrofluoric acid, respectively.

In this case, the nanofibers 111 forming the nanofibrous membrane 110 may comprise, or may be made of, a material being resistant against an etchant (e.g., hydrofluoric acid) being used in the chemical wet etching process. Thus, when applying the wet chemical etching process, the etchant-sensitive sacrificial layer 150 is selectively removed such that the etchant-resistant nanofibrous membrane 110 remains.

According to an alternative second method, the step of removing the sacrificial layer 150 may be performed by applying a high-temperature ashing process, such as plasma ashing, for example. In this case, the sacrificial layer 150 may comprise, or may be made of, a carbon-based material for being removed by the high-temperature ashing process. For example, the sacrificial layer 150 may comprise, or may be made of, pyrolytic carbon or graphene.

The nanofibers 111, in turn, may comprise, or may be made of, at least one of a high-temperature stable material for withstanding the high-temperature ashing process. For example, the nanofibers 111 may comprise, or may be made of, at least one of high-temperature stable polymer materials (e.g., polytetrafluoroethylene (PTFE) and polyimide (PI)) or ceramic / metal-oxide-based materials (e.g., aluminum oxide (Al₂O₃), silicon dioxide (SiO₂), tin oxide (SnO₂), and copper oxide (CuO)) or composite materials.

In case of ceramics, the nanofibers 111 may be further processed after electrospinning or blowspinning. For example, the nanofibers 111 may be subjected to a so-called calcination. The nanofibers 111 may be created in hybrid or composite fashion, i.e., one of the polymer types can be combined with others (either another polymer or oxide, or carbon, or other nanomaterials).

Accordingly, an optional step of the innovative method may include depositing nanofibers 111 comprising different materials and/or different diameters among each other, i.e., a nanofibrous membrane 110 comprising nanofibers 111 with different diameters and material types (hybrid) can be produced. For example, different sizes of spinning-material applicators (e.g., needles) can be used when performing electrospinning or blowspinning. Alternatively, two identical applicators (e.g., needles) may be used, but different material recipes or parameters are used during the spinning process. Regarding a material of the nanofibers 111, more than one material type (hybrid) can be used. Accordingly, nanofibers 111 with more than one diameter size distribution and/or with more than one material source may be produced by subsequent or simultaneous spinning processes, in which the synergistic effects of different nanofibers 111 can then improve the robustness of the nanofibrous membrane 110.

As a further optional step, the herein described innovative method may comprise a step of post-processing of the spun nanofibers 111 by applying a solvent vaporization and/or a heat treatment for creating cross-linked nanofibers 111. By doing so, the single spun nanofibers 111 can join and create cross-linked structures among them. This may significantly improve a mechanical robustness of the nanofibrous membrane 110. Accordingly, instead of applying one or more separated nanofibers 111, the spun nanofibers 111 can be created in cross-linked structures.

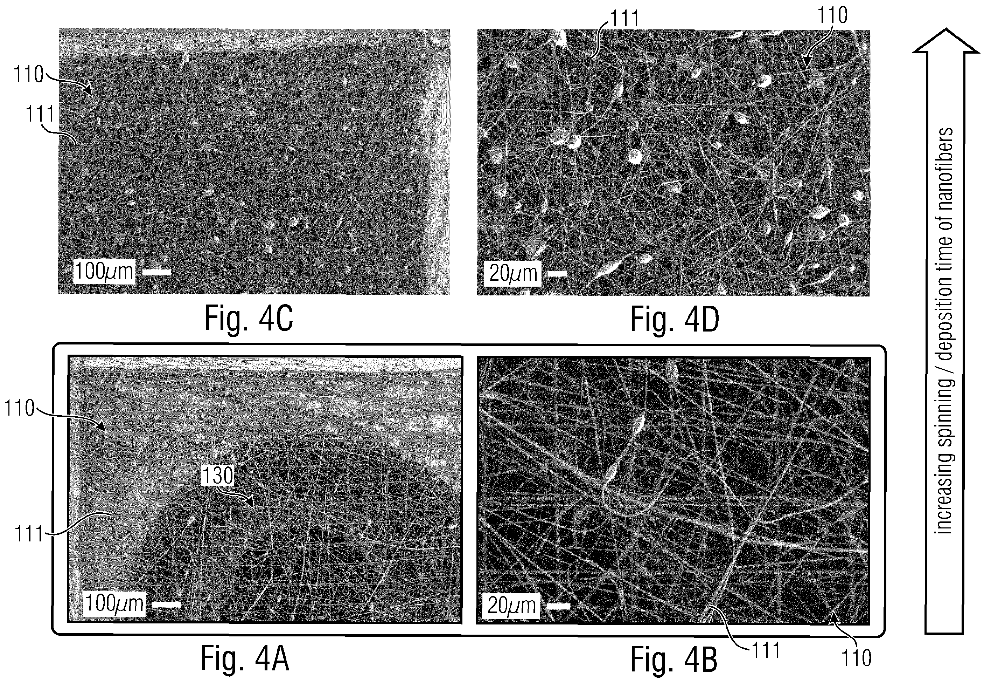

Figures 4A to 4D show SEM images of a portion of an innovative nanofibrous membrane 110 being made from spun nanofibers 111. In this non-limiting example, the nanofibers 111 are spun onto a substrate, such as substrate 120 shown in Figure 2A, with directly covering the through hole 130.

Figure 4A shows the spun / deposited nanofibers 111 at a resolution of 100 µm. Figure 4B shows the same SEM image as Figure 4A but with a higher resolution of 20 µm. As can be seen, the nanofibrous membrane 110 may comprise a low fiber density.

Figure 4C shows the same substrate, but in a state in which the spinning / deposition time has been increased compared to Figures 4A and 4B. As can be seen, the fiber density can be increased by increasing the spinning / deposition time. Figure 4D shows the same SEM image as Figure 4C but with a higher resolution of 20 µm.

In any case, environmental barrier membranes 110 being made from spun nanofibers 111 show a characteristic structure that allows to structurally distinguish them from other environmental barrier membranes which are not made from spun nanofibers 111, such as ePTFE membranes. For example, the nanofibrous membranes 110 may comprise structural features that do not appear in ePTFE membranes and the other way around.

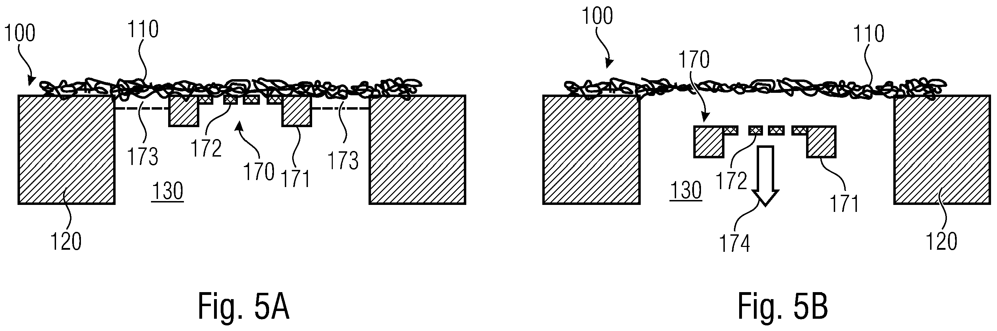

Figures 5A and 5B show a third alternative method for producing an environmental barrier chip 100 with a nanofibrous air-permeable and mechanically compliant environmental barrier membrane 110. According to this third alternative, an additional microstructured carrier structure 170 may be provided inside the through hole 130. The carrier structure 170 may be configured as a chip comprising a substrate 171. The substrate 171 may comprise, or may be made of, a semiconductor material, glass or polymers. Optionally, the substrate 171 may comprise a membrane 172. The carrier structure 170 may be suspended inside the through hole 130 by means of one or more breakable beams 173.

In this case, the step of depositing the nanofibers 111 may comprise depositing the nanofibers 111 onto the carrier structure 170, for example onto the substrate 171 and/or the membrane 172. Thus, the carrier structure 170 may act as a support for supporting the spun nanofibers 111 during deposition / spinning.

After the nanofibers 111 have been applied, the method may further comprise a step of breaking the breakable beams 173 and removing (as indicated by arrow 174) the carrier structure 170 from the through hole 130 for releasing the nanofibrous membrane 110 made from the deposited nanofibers 111.

So far, the innovative method has been exemplarily discussed on chip-level, i.e., with reference to single environmental barrier chips 100. However, one of several advantages of the present innovation is the possibility to perform the method on wafer-level for parallelizing the manufacturing process in order to enhance the yield and save production costs.

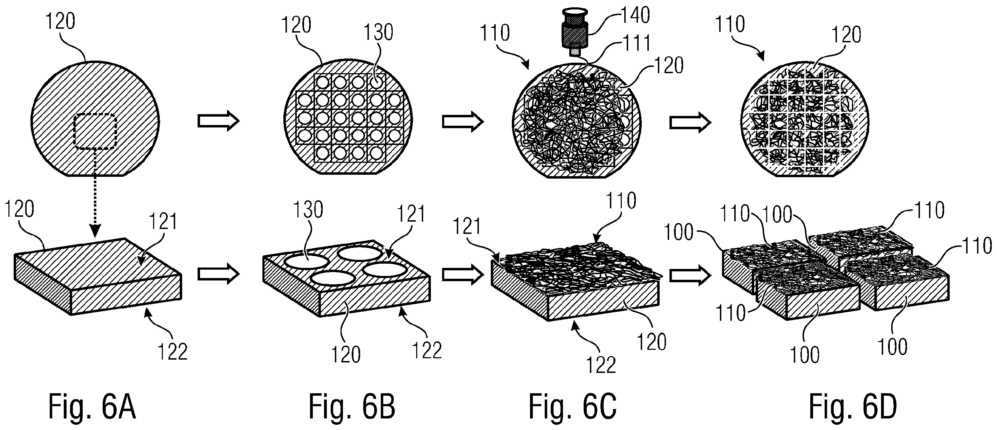

Figures 6A to 6D show a process flow of an innovative method for producing a plurality of environmental barrier chips 100 on wafer-level, i.e., the above discussed substrate 120 may be provided as a wafer. This embodiment may correspond to the previously discussed embodiment as shown in Figures 2A and 2B, in which the nanofibers 111 are directly spun onto the substrate 120 without a temporary sacrificial layer 150.

In each of Figures 6A to 6D, a respective top drawing shows a top view of the wafer 120, while a bottom drawing shows a perspective view of the wafer 120. Fig. 6A shows the unprocessed bare wafer 120. The wafer 120 may be, for example, a silicon wafer. As can be seen in Figure 6B, a plurality of the above discussed through holes 130 may be structured into the wafer 120, wherein each through hole 130 may extend vertically through the wafer 120 between two opposite sides 121, 122 of the wafer 120. The through holes 130 may be created by etching, e.g., by means of DRIE / Bosch etching.

Figure 6C shows a further method step, in which the nanofibers 111 are deposited onto the at least one of the two opposite wafer surfaces 121, 122 for covering said plurality of through holes 130 provided in the wafer 120. The nanofibers 111 may be deposited e.g., by blowspinning or electrospinning as symbolized by tool 140. An optional adhesion promotion layer (not shown) may be deposited onto the respective wafer surface 121, 122 prior to applying the nanofibers 111. The spun nanofibers 111 combine to a network of nanofibers that forms a free-standing and mechanically compliant nanofibrous membrane 110 covering the plurality of the previously uncovered through holes 130.

Figure 6D shows a further method step in which the individual environmental barrier chips 100 may be singulated from the wafer 120, e.g., by means of dicing, sawing, etc. In result, a plurality of environmental barrier chips 100 may be created, wherein each environmental barrier chip 100 comprises its own free-standing and mechanically compliant nanofibrous membrane 110.

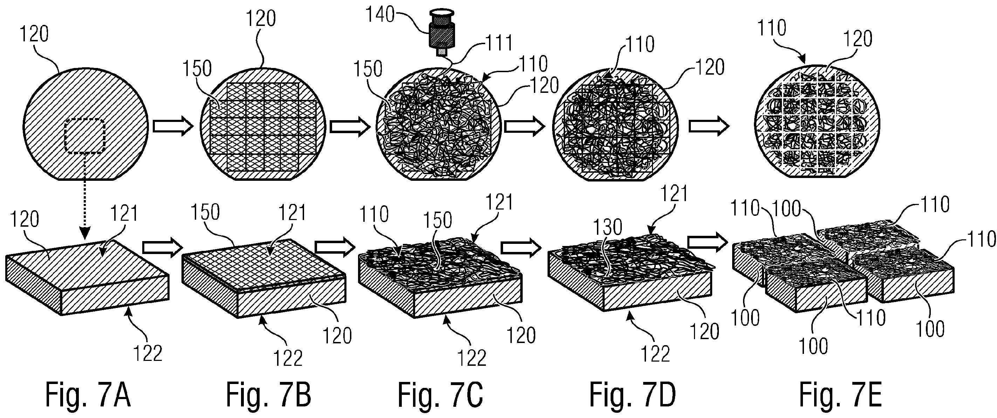

Figures 7A to 7E show an alternative process flow for producing a plurality of environmental barrier chips 100 on wafer-level, i.e., the above discussed substrate 120 may again be provided as a wafer. This embodiment may correspond to the previously discussed embodiment as shown in Figures 3A and 3B, in which the nanofibers 111 are spun onto a temporary sacrificial layer 150 being deposited onto the substrate 120.

In each of Figures 7A to 7E, a respective top drawing shows a top view of the wafer 120, while a bottom drawing shows a perspective view of the wafer 120. Fig. 7A shows the unprocessed bare wafer 120. The wafer 120 may be, for example, a silicon wafer. As can be seen in Figure 7B, a temporary sacrificial layer 150 may be deposited onto at least one of the two opposite wafer surfaces 121, 122. In a further method step, the above discussed plurality of through holes 130 may be structured into the wafer 120. They may be structured into the wafer 120 beginning from the opposite second wafer surface 122, i.e., from the opposite side of the deposited temporary sacrificial layer 150. Thus, the through holes 130 are not visible in Figure 7B.

Figure 7C shows a further method step in which the nanofibers 111 are deposited onto the temporary sacrificial layer 150, e.g., by blowspinning or electrospinning as symbolized by tool 140. An optional adhesion promotion layer (not shown) may be deposited onto the temporary sacrificial layer 150 prior to applying the nanofibers 111. The spun nanofibers 111 combine to a network of nanofibers that forms a mechanically compliant nanofibrous membrane 110 being supported by the temporary sacrificial layer 150.

Figure 7D shows a further method step in which the temporary sacrificial layer 150 is removed. As discussed above, the temporary sacrificial layer 150 may be removed, for example by means of etching, ashing or mechanical removal with the help of a support structure 170. By removing the sacrificial layer 150, the through holes 130 become uncovered and thus visible. The nanofibers 111, however, are not removed, i.e., they remain on the at least one wafer surface 121, 122 on which the temporary sacrificial layer 150 was placed before. Since the nanofibrous membrane 110 is now arranged directly on the wafer 120, the nanofibrous membrane 110 now covers the plurality of through holes 130.

Figure 7E shows a further method step in which the individual environmental barrier chips 100 may be singulated from the wafer 120, e.g., by means of dicing, sawing, etc. In result, a plurality of environmental barrier chips 100 may be created, wherein each environmental barrier chip 100 comprises its own free-standing and mechanically compliant nanofibrous membrane 110.

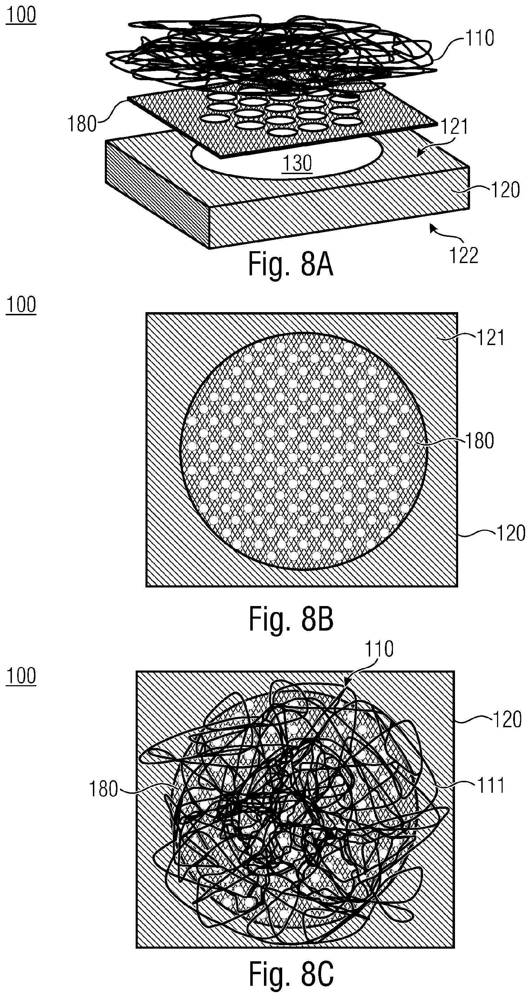

Figures 8A to 8C show a further example of an innovative method for producing a plurality of environmental barrier chips 100 on chip-level. This environmental barrier chip 100 may substantially correspond to the above discussed environmental barrier chips 100. Thus, everything that was mentioned with respect to the previous Figures also holds for the environmental barrier chip 100 of Figures 8A to 8C.

A difference compared to the previously discussed embodiments is the provision of a permanent environmental barrier structure 180 being arranged between the substrate 120 and the nanofibrous membrane 110, as depicted in the exploded view in Figure 8A. This environmental barrier structure 180 may correspond to the environmental barrier structure as described in EP 22 210 912.6 and EP 22 210 899.5 which are enclosed by reference herein.

As shown in Figure 8B, the permanent environmental barrier structure 180 may be arranged on at least one of the two substrate surfaces 121, 122. The environmental barrier structure 180 may be configured as a mechanically compliant / flexible membrane comprising perforations for allowing a fluid exchange. As shown in Figure 8C, one or more nanofibers 111 may be deposited / spun onto the environmental barrier structure 180, wherein the spun nanofibers 111 combine to a network of nanofibers that forms a nanofibrous membrane 110.

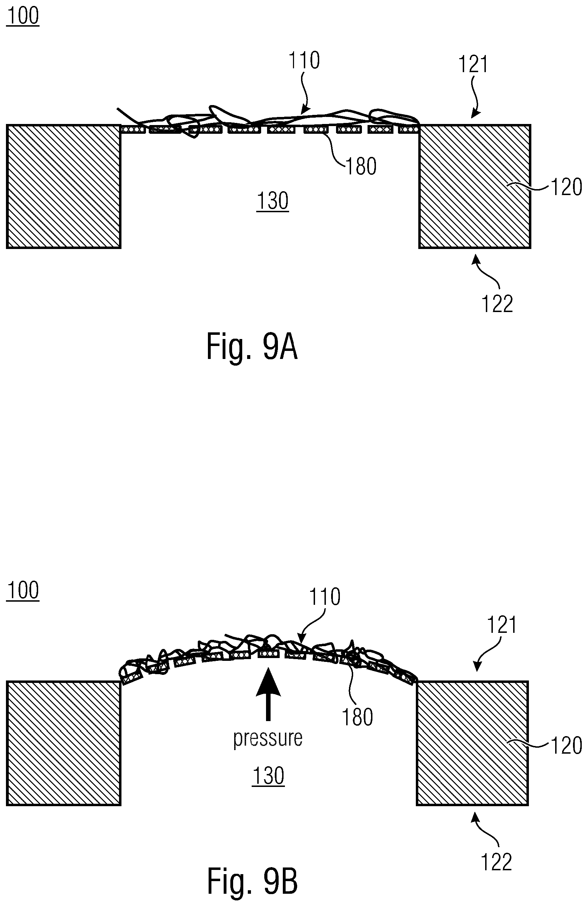

Figures 9A and 9B show side elevational views of the environmental barrier chip 100 comprising the aforementioned permanent environmental barrier structure 180 with the nanofibrous membrane 110 formed thereon. Figure 9A shows a situation in which no external force is applied to the environmental barrier structure 180. The environmental barrier structure 180 is in its initial state in which it is not deflected. Figure 9B shows a scenario in which an external force, e.g., pressure, is applied to the environmental barrier structure 180. Since the environmental barrier structure 180 may be configured as a mechanically compliant / flexible structure, the environmental barrier structure 180 may be deflected in response to the applied force. The nanofibrous membrane 100 may also be deflected together with the environmental barrier structure 180.

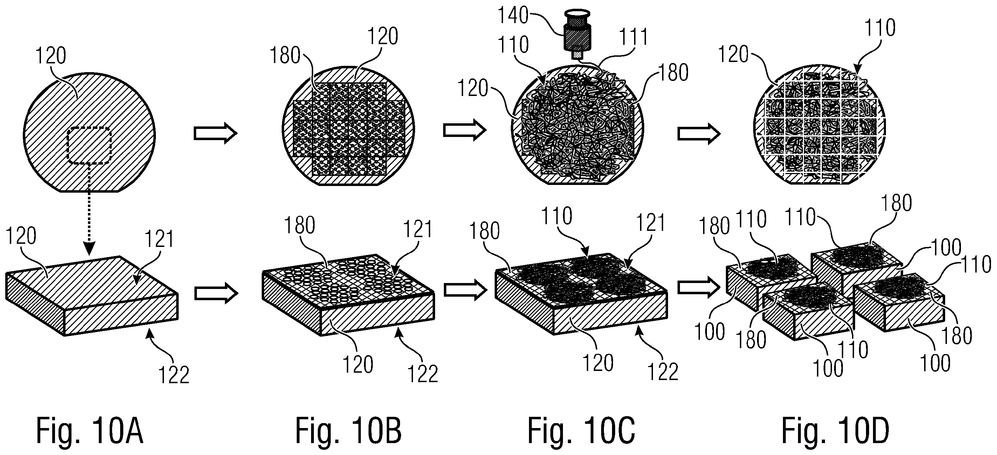

Figures 10A to 10D show a process flow of a method for producing a plurality of environmental barrier chips 100 on wafer-level, i.e., the above discussed substrate 120 may again be provided as a wafer. This embodiment may correspond to the previously discussed embodiment as shown in Figures 8A to 8C, in which the nanofibers 111 are spun onto a permanent environmental barrier structure 180 being arranged on the substrate 120.

In each of Figures 10A to 10D, a respective top drawing shows a top view of the wafer 120, while a bottom drawing shows a perspective view of the wafer 120. Fig. 10A shows the unprocessed bare wafer 120. The wafer 120 may be, for example, a silicon wafer. As can be seen in Figure 10B, a permanent environmental barrier structure 180 may be arranged on at least one of the two opposite wafer surfaces 121, 122. The permanent environmental barrier structure 180 may be configured as a perforated mechanically compliant membrane. In a further method step, the above discussed plurality of through holes 130 may be structured into the wafer 120. They may be structured into the wafer 120 from the opposite second wafer surface 122, i.e., from the opposite side of the permanent environmental barrier structure 180. Thus, the through holes 130 are merely indicated in Figure 10B underneath the perforations.

Figure 10C shows a further method step in which the nanofibers 111 are deposited onto the permanent environmental barrier structure 180, e.g., by blowspinning or electrospinning as symbolized by tool 140. The spun nanofibers 111 combine to a network of nanofibers that forms a mechanically compliant nanofibrous membrane 110 being supported by the permanent environmental barrier structure 180.

Figure 10D shows a further method step in which the individual environmental barrier chips 100 may be singulated from the wafer 120, e.g., by means of dicing, sawing, etc. In result, a plurality of environmental barrier chips 100 may be created, wherein each environmental barrier chip 100 comprises its own mechanically compliant nanofibrous membrane 110 being supported by the mechanically compliant permanent environmental barrier structure 180.

Summarizing, the herein described innovative concepts provides different alternative methods for manufacturing an environmental barrier chip 110 comprising a nanofibrous and mechanically compliant air-permeable environmental barrier membrane 110. Some embodiments provide devices and fabrication methods of (semiconductor) wafer-level processed environmental barrier modules 100, which comprise either free-standing or softly (compliant) supported nanofiber membranes 110.

It is suggested to provide several possible embodiments and manufacturing methods to produce compliant nanofibrous environmental barrier membranes 111 using wafer-level processing methods combined with spun nanofiber material. Manufacturing costs may be significantly reduced since fabrication techniques from the semiconductor industry, such as wafer-level processing, can be applied.

The structure of interest may comprise a substrate 120 (single-chip or wafer), with an e.g., deep-reactive-ion-etched through hole 130. At least one side of the through hole 130 may be covered by a network of nanofibers 111 that forms a compliant and air-permeable environmental barrier membrane 110.

In one alternative method (Figs. 7-7E), the nanofiber membrane 110 may be deposited on a sacrificial carrier layer 150 that is subsequently removed. According to this method, the nanofibers 111 may be deposited (e.g., by applying an electrospinning or blowspinning method) on a sacrificial carrier layer 150 covering the though hole 130 of the environmental barrier chip 100. By removing the sacrificial layer 150 (via e.g., etching, ashing, or mechanical removal), a free-standing nanofiber membrane 110 can be released.

An exemplary production method, as depicted in Figures 7A-7E, starts with a bare silicon wafer 100. Next, silicon oxide (e.g., TEOS or other types of oxide) may be deposited on the wafer 120 which may act as an etch-stop for the DRIE (Bosch) etching and as a sacrificial carrier layer 150 for the nanofibers 111. Subsequently, through holes 130 may be etched through the wafer substrate 120 via Bosch etching. Nanofibers 111 (e.g., PTFE) may then be deposited on the silicon oxide layer 150 via an electrospinning or blowspinning method. The silicon oxide layer 150 may then be removed via e.g., vapor or liquid HF-etching, releasing a free-standing nanofibrous environmental barrier membrane 110. Considering a production on wafer-level, individual chips 100 may finally be singulated via dicing methods. For instance, individual environmental barrier chips 100 may be singulated via dicing methods to form chips 100 with each containing a nanofibrous and mechanically compliant free-standing environmental barrier membrane 110.

In case the temporary sacrificial layer 150 is removed by etching, a silicon oxide may be used as a carrier layer 150 and an HF-resistant material may be used for the nanofibers 111. HF-resistant nanofiber material may include, e.g., noryl, polyethylene, polypropylene (homopolymer), PTFE.

In case the temporary sacrificial layer 150 is removed by ashing (at temperatures of 250°C and above), a carbon-based carrier layer 150 may be used which can be removed during the ashing process. Nanofiber material may include, e.g., metal oxide or ceramic based nanofibers (e.g., Al₂O₃, SiO₂, SnO₂, CuO) and high temperature stable polymer nanofibers (e.g., PTFE and polyimide (PI) can be opted as the fiber materials).

A further alternative method suggests mechanical removal methods of a carrier via e.g., breaking device or the so-called chip-in-chip methods. As exemplarily shown in Figures 5A and 5B, an inner chip 170 may be suspended inside the through hole 130 by means of thin beams 173, wherein an outer chip surface may be covered by a nanofiber network. Breaking out the beam suspended inner chip 170 (by breaking the beams 173) may release a free-standing nanofibrous membrane 110. In case of mechanical removal, the above-mentioned chip-in-chip concept (breaking out inner device 170) may be used, wherein a low adhesion of the nanofibers 111 may be desirable.

According to a further alternative method, the nanofibers 111 may be directly deposited / spun onto a substrate 120, e.g., onto a pre-structured Si wafer. In this case, the aforementioned temporary sacrificial layer 150 is omitted. Since no additional sacrificial carrier layer 150 is needed, the nanofibers 111 can be directly deposited / spun on a pre-structured Si wafer 120. An exemplary process flow is shown in Figures 6A-6D. A bare wafer 120 may be pre-structured to contain vertical through holes 130. Subsequently, the nanofiber network may be deposited over the full wafer 120. Here, the diameter of the through holes 130 may influence the feasibility of the membrane 110 to be stable anchoring on the substrate frame 120. Through holes with too large diameters may lead the nanofibers 111 to fall or drop into it. Thus, the through holes 130 as described herein may comprise sizes (e.g., diameters) such that the spun nanofibers 111 are not expected to fall into the through hole 130 but still form a nanofibrous membrane 110 on top of the full wafer 120. In a final step, individual environmental barrier chips 100 may be singulated via dicing methods to form chips 100 with each containing a nanofibrous and mechanically compliant free-standing environmental barrier membrane 110.

Each of the herein described environmental barrier chips 100 may be produced on wafer-level with a subsequent chip singulation or on chip-level with single chip processing of the nanofibers 111 on already singulated chips 100.

Due to the fabrication flow and to increase the adhesion of nanofibers 111 with the underlying substrate 120, additional layers may be incorporated, e.g., a silicon oxide layer may remain on the wafer (preferred for Bosch etching and does not need to be removed), or an adhesion promoting layer may be applied to improve stability of the nanofibers 111 on the substrate 120 (e.g., rough surface, adhesion promoting materials).

According to a yet further method, nanofibers 111 may be applied, which are supported by a permanent environmental barrier structure 180, such as a very thin compliant carrier membrane. In this case, the nanofibrous membrane 110 is not free-standing but supported by the environmental barrier structure 180. As exemplarily shown in Figs. 10A-10D, the nanofibers 111 may be deposited on a very compliant (e.g., very thin) carrier layer 180, which permanently remains as a support structure in the final environmental barrier chips 100.

As shown in Figures 10A-10D, an exemplary fabrication method may start on a Si wafer 120, where a layer of the later carrier material 180 will be deposited and structured. Free-standing membranes of the carrier layer 180 may be formed via a backside DRIE process, where a through hole 130 may be created in the wafer substrate 120. Subsequently, the nanofibers 111 may be deposited / spun on the pre-structured wafer 120 followed by a singulation of the wafer 120 into individual environmental barrier chips 100.

Also in this case, theoretically both a wafer-level production with a subsequent chip singulation and single chip processing of the nanofibers 111 on already singulated chips 100 can be done.

The permanent carrier layer 180 may provide some advantageous properties (i.e., high compliance, high perforation/porosity, high temperature stability, and good chemical resistance) to realize an environmental barrier membrane module 100 with low SNR loss that can be later integrated with a microphone package. The materials selected for this carrier layer 180 may be stable during the reflow soldering process (e.g., a peak temperature of 260°C). Moreover, on the one hand the mechanical compliance of the resulting carrier layer membrane 180 should ideally be larger than the mechanical compliance of the subsequently deposited nanofibers 111 in order to not reduce the mechanical compliance of the environmental barrier membrane stack (comprising carrier layer 180 and nanofibrous membrane 110) compared to a pure nanofibrous membrane as in the other alternative methods. A highly compliant carrier layer 180 may be realized by either depositing a very low intrinsic tensile stress material (ideally stress-free) or depositing a very thin, ideally 2D, material. In previous studies, 100 nm layer of mono-Si showed to be highly compliant. Moreover, carbon-based materials such as graphene, graphenic carbon, and pyrolytic carbon can be of interest. Depending on the geometries of the created membranes (e.g., membrane thickness and diameter), their mechanical robustness and compliance can be adjusted.

Thin materials may include mono-silicon which shows an extremely high mechanical compliance. Thin materials may further include poly-silicon, which shows a very high mechanical compliance at thicknesses of 150 nm and less. Thin materials may further include carbon-based materials (e.g., graphene, graphenic carbon, pyrolytic carbon). Pyrolytic carbon can demonstrate extremely high mechanical compliances of around 2 - 20 µm / Pa with high robustness level.

On the other hand, the carrier layer 180 should not significantly alter the air permeability of the environmental barrier membrane stack (carrier layer membrane 180 and nanofibrous membrane 110) compared to a bare nanofibrous membrane as in the other alternative methods. Therefore, it needs to be highly perforated or intrinsically nano-/mesoporous.

It is contemplated that environmental barrier chips 100 being manufactured according to one of the herein described methods may allow to create MEMS microphones with an integrated environmental protection. MEMS microphones with an integrated environmental protection would simplify the system implementation for manufacturers since they would not have to deal with finding good environmental barrier components and their proper placement in the sound-channel or system.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

While this disclosure has been described with reference to illustrative embodiments, this description is not intended to be construed in a limiting sense. Various modifications and combinations of the illustrative embodiments of this disclosure, will be apparent to persons skilled in the art upon reference to the description. The scope of protection is solely defined by the set of appended claims.

## Claims

1. A method for producing an environmental barrier chip (100) comprising a microstructured air-permeable environmental barrier membrane (110), the method comprising at least the following steps:
providing a substrate (120), and structuring a through hole (130) into the substrate (120), the through hole (130) extending fully through the substrate (120) between two opposite surfaces (121, 122) of the substrate (120),
leaving the through hole (130) uncovered and depositing one or more nanofibers (111) onto at least one of the two opposite substrate surfaces (121, 122) by applying at least one of an electrospinning or blowspinning method, such that the spun nanofibers (111) combine to a network of nanofibers that forms a free-standing and mechanically compliant nanofibrous membrane (110) covering the previously uncovered through hole (130) of the environmental barrier chip (100).

2. A method for producing an environmental barrier chip (100) comprising a microstructured air-permeable environmental barrier membrane (110), the method comprising at least the following steps:
providing a substrate (120) having a first substrate surface (121) and an opposite second substrate surface (122),
depositing a sacrificial layer (150) onto at least one of the two opposite substrate surfaces (121, 122),
structuring a through hole (130) into the substrate (120), the through hole extending fully through the substrate (120) between the two opposite substrate surfaces (121, 122), wherein the sacrificial layer (150) remains and covers the through hole (130),
depositing one or more nanofibers (111) onto the sacrificial layer (150) by applying at least one of an electrospinning or blowspinning method, such that the spun nanofibers (111) combine to a network of nanofibers that forms a nanofibrous membrane (110), and
removing the sacrificial layer (150) for releasing the nanofibrous membrane (110), wherein the released nanofibrous membrane (110) forms a free-standing and mechanically compliant nanofibrous membrane (110) covering the through hole (130).

3. The method according to claim 2,
wherein the step of depositing the sacrificial layer (150) comprises depositing a silicon oxide layer, and
wherein the step of removing the sacrificial layer (150) is performed by applying a chemical wet-etching process.

4. The method according to claim 3,
wherein the step of depositing the nanofibers (111) comprises depositing nanofibers (111) comprising, or being made of, a material being resistant against an etchant being used in the chemical wet-etching process.

5. The method according to claim 2,
wherein the step of removing the sacrificial layer (150) is performed by applying a high-temperature ashing process.

6. The method according to claim 5,
wherein the step of depositing the sacrificial layer (150) comprises depositing a sacrificial layer (150) comprising, or being made of, a carbon-based material for being removed by the high-temperature ashing process.

7. The method according to claim 5 or 6,
wherein the step of depositing the nanofibers (111) comprises depositing nanofibers (111) comprising, or being made of, at least one of a high-temperature stable polymer material or a ceramic-based material or a metal oxide material for withstanding the high-temperature ashing process.

8. The method according to claim 1 or 2,
further comprising a step of providing a microstructured carrier structure (170) inside the through hole (130), the carrier structure (170) being suspended by means of breakable beams (173),
wherein the step of depositing the nanofibers (111) comprises depositing the nanofibers (111) onto the carrier structure (170), and
wherein the method further comprises a step of breaking the breakable beams (173) and removing the carrier structure (170) from the through hole (130) for releasing the nanofibrous membrane (110) made from the deposited nanofibers (111).

9. The method according to any one of the preceding claims,
further comprising a step of depositing an adhesion promotion layer onto the at least one of the two opposite substrate surfaces (121, 122), and
wherein the step of depositing the nanofibers (111) comprises depositing the nanofibers (111) onto the adhesion promotion layer.

10. The method according to any one of the preceding claims,
the method being performed on wafer-level,
wherein the substrate (120) is provided as a wafer comprising a plurality of said through holes (130), and
wherein the step of depositing the nanofibers (111) comprises depositing the nanofibers (111) onto the at least one of the two opposite substrate surfaces (121, 122) of the wafer (120) for covering said plurality of through holes (130) in the wafer (120).

11. The method according to any one of claims 1 to 9,
the method being performed on chip-level,
wherein the substrate (120) is provided as a single chip having a single through hole (130), and
wherein the step of depositing the nanofibers (111) comprises depositing the nanofibers (111) onto the at least one of the two opposite substrate surfaces (121, 122) of the single chip (120) for covering said single through hole (130) in the chip (120).

12. The method according to any one of the preceding claims,
further comprising a step of post-processing of the spun nanofibers (111) by applying a solvent vaporization and/or a heat treatment for creating cross-linked nanofibers (111).

13. The method according to any one of the preceding claims,
wherein the step of depositing the nanofibers (111) comprises depositing nanofibers (111) comprising different materials and/or different diameters among each other.

14. An environmental barrier chip (100) with an air-permeable environmental barrier membrane (110), the environmental barrier chip (100) comprising
a substrate (120) comprising a through hole (130) extending fully through two opposite surfaces (121, 122) of the substrate (120),
wherein a free-standing and mechanically compliant nanofibrous membrane (110) is arranged on at least one of the two opposite surfaces (121, 122) of the substrate (120), such that the nanofibrous membrane (110) covers the through hole (130),
wherein the nanofibrous membrane (110) is formed by a network of spun nanofibers (111) being arranged on the at least one of the two opposite surfaces (121, 122) of the substrate (120).

## Patentansprüche

1. Ein Verfahren zum Herstellen eines Umgebungsbarrierechips (100), der eine mikrostrukturierte luftdurchlässige Umgebungsbarrieremembran (110) aufweist, wobei das Verfahren zumindest die folgenden Schritte aufweist:
Bereitstellen eines Substrats (120) und Strukturieren eines Durchgangslochs (130) in das Substrat (120), wobei sich das Durchgangsloch (130) vollständig durch das Substrat (120) zwischen zwei gegenüberliegenden Oberflächen (121, 122) des Substrats (120) erstreckt,
Unbedecktbelassen des Durchgangslochs (130) und Abscheiden einer oder mehrerer Nanofasern (111) auf zumindest einer der zwei gegenüberliegenden Substratoberflächen (121, 122) durch Anwenden zumindest eines von einem Elektrospinn- oder einem Blasspinnverfahren, so dass die gesponnenen Nanofasern (111) zu einem Netzwerk von Nanofasern kombiniert werden, das eine freistehende und mechanisch nachgiebige Nanofasermembran (110) bildet, die das zuvor unbedeckte Durchgangsloch (130) des Umgebungsbarrierechips (100) bedeckt.

2. Ein Verfahren zum Herstellen eines Umgebungsbarrierechips (100), der eine mikrostrukturierte luftdurchlässige Umgebungsbarrieremembran (110) aufweist, wobei das Verfahren zumindest die folgenden Schritte aufweist:
Bereitstellen eines Substrats (120) mit einer ersten Substratoberfläche (121) und einer gegenüberliegenden zweiten Substratoberfläche (122),
Abscheiden einer Opferschicht (150) auf zumindest einer der zwei gegenüberliegenden Substratoberflächen (121, 122),
Strukturieren eines Durchgangslochs (130) in das Substrat (120), wobei sich das Durchgangsloch vollständig durch das Substrat (120) zwischen den zwei gegenüberliegenden Substratoberflächen (121, 122) erstreckt, wobei die Opferschicht (150) verbleibt und das Durchgangsloch (130) bedeckt,
Abscheiden einer oder mehrerer Nanofasern (111) auf die Opferschicht (150) durch Anwenden zumindest eines von einem Elektrospinn- oder einem Blasspinnverfahren, so dass die gesponnenen Nanofasern (111) zu einem Netzwerk von Nanofasern kombiniert werden, das eine Nanofasermembran (110) bildet, und
Entfernen der Opferschicht (150) zum Freigeben der Nanofasermembran (110), wobei die freigegebene Nanofasermembran (110) eine freistehende und mechanisch nachgiebige Nanofasermembran (110) bildet, die das Durchgangsloch (130) bedeckt.

3. Das Verfahren gemäß Anspruch 2,
wobei der Schritt des Abscheidens der Opferschicht (150) ein Abscheiden einer Siliziumoxidschicht aufweist, und
wobei der Schritt des Entfernens der Opferschicht (150) durch Anwenden eines chemischen Nassätzprozesses durchgeführt wird.

4. Das Verfahren gemäß Anspruch 3,
wobei der Schritt des Abscheidens der Nanofasern (111) ein Abscheiden von Nanofasern (111) aufweist, die ein Material aufweisen oder daraus hergestellt sind, das gegenüber einem Ätzmittel beständig ist, das in dem chemischen Nassätzprozess verwendet wird.

5. Das Verfahren gemäß Anspruch 2,
wobei der Schritt des Entfernens der Opferschicht (150) durch Anwenden eines Hochtemperaturveraschungsprozesses durchgeführt wird.

6. Das Verfahren gemäß Anspruch 5,
wobei der Schritt des Abscheidens der Opferschicht (150) ein Abscheiden einer Opferschicht (150) aufweist, die ein Material auf Kohlenstoffbasis aufweist oder daraus hergestellt ist, um durch den Hochtemperaturveraschungsprozess entfernt zu werden.

7. Das Verfahren gemäß Anspruch 5 oder 6,
wobei der Schritt des Abscheidens der Nanofasern (111) ein Abscheiden von Nanofasern (111) aufweist, die zumindest eines von einem hochtemperaturstabilen Polymermaterial oder einem Material auf Keramikbasis oder einem Metalloxidmaterial aufweisen oder daraus hergestellt sind, um dem Hochtemperaturveraschungsprozess zu widerstehen.

8. Das Verfahren gemäß Anspruch 1 oder 2,
das ferner einen Schritt des Bereitstellens einer mikrostrukturierten Trägerstruktur (170) innerhalb des Durchgangslochs (130) aufweist, wobei die Trägerstruktur (170) mittels brechbarer Balken (173) aufgehängt ist,
wobei der Schritt des Abscheidens der Nanofasern (111) ein Abscheiden der Nanofasern (111) auf die Trägerstruktur (170) aufweist, und
wobei das Verfahren ferner einen Schritt des Brechens der brechbaren Balken (173) und des Entfernens der Trägerstruktur (170) aus dem Durchgangsloch (130) zum Freigeben der Nanofasermembran (110) aufweist, die aus den abgeschiedenen Nanofasern (111) hergestellt ist.

9. Das Verfahren gemäß einem der vorhergehenden Ansprüche,
das ferner einen Schritt des Abscheidens einer haftungsfördernden Schicht auf die zumindest eine der zwei gegenüberliegenden Substratoberflächen (121, 122) aufweist, und
wobei der Schritt des Abscheidens der Nanofasern (111) ein Abscheiden der Nanofasern (111) auf die haftungsfördernde Schicht aufweist.

10. Das Verfahren gemäß einem der vorhergehenden Ansprüche,
wobei das Verfahren auf Waferebene durchgeführt wird,
wobei das Substrat (120) als ein Wafer bereitgestellt wird, der eine Mehrzahl der Durchgangslöcher (130) aufweist, und
wobei der Schritt des Abscheidens der Nanofasern (111) ein Abscheiden der Nanofasern (111) auf die zumindest eine der zwei gegenüberliegenden Substratoberflächen (121, 122) des Wafers (120) zum Bedecken der Mehrzahl von Durchgangslöchern (130) in dem Wafer (120) aufweist.

11. Das Verfahren gemäß einem der Ansprüche 1 bis 9,
wobei das Verfahren auf Chipebene durchgeführt wird,
wobei das Substrat (120) als ein einzelner Chip mit einem einzelnen Durchgangsloch (130) bereitgestellt wird, und
wobei der Schritt des Abscheidens der Nanofasern (111) ein Abscheiden der Nanofasern (111) auf die zumindest eine der zwei gegenüberliegenden Substratoberflächen (121, 122) des einzelnen Chips (120) zum Bedecken des einzelnen Durchgangslochs (130) in dem Chip (120) aufweist.

12. Das Verfahren gemäß einem der vorhergehenden Ansprüche,
ferner aufweisend einen Schritt eines Nachverarbeitens der gesponnenen Nanofasern (111) durch Anwenden einer Lösungsmittelverdampfung und/oder einer Wärmebehandlung zum Erzeugen von vernetzten Nanofasern (111).

13. Das Verfahren gemäß einem der vorhergehenden Ansprüche,
wobei der Schritt des Abscheidens der Nanofasern (111) ein Abscheiden von Nanofasern (111) aufweist, die unterschiedliche Materialien und/oder unterschiedliche Durchmesser untereinander aufweisen.

14. Ein Umgebungsbarrierechip (100) mit einer luftdurchlässigen Umgebungsbarrieremembran (110), wobei der Umgebungsbarrierechip (100) Folgendes aufweist:
ein Substrat (120), das ein Durchgangsloch (130) aufweist, das sich vollständig durch zwei gegenüberliegende Oberflächen (121, 122) des Substrats (120) erstreckt, wobei eine freistehende und mechanisch nachgiebige Nanofasermembran (110) auf zumindest einer der zwei gegenüberliegenden Oberflächen (121, 122) des Substrats (120) angeordnet ist, so dass die Nanofasermembran (110) das Durchgangsloch (130) bedeckt,
wobei die Nanofasermembran (110) durch ein Netzwerk von gesponnenen Nanofasern (111) gebildet wird, das auf der zumindest einen der zwei gegenüberliegenden Oberflächen (121, 122) des Substrats (120) angeordnet ist.

## Revendications

1. Un procédé de production d'une puce (100) barrière environnementale comprenant une membrane (110) barrière environnementale micro-structurée perméable à l'air, le procédé comprenant au moins les stades suivants :
se procurer un substrat (120) et structurer un trou (130) traversant dans le substrat (120), le trou (130) traversant traversant entièrement le substrat (120) entre deux surfaces (121, 122) opposées du substrat (120),
laisser le trou (130) traversant à découvert et déposer une ou plusieurs nanofibres (111) sur au moins l'une des deux surfaces (121, 122) opposées du substrat en appliquant au moins l'un d'un procédé par électro-filage ou par filage par soufflage, de manière à ce que les nanofibres (111) filées se combinent en un réseau de nanofibres, qui forme une membrane (110) nanofibreuse indépendante et se conformant mécaniquement recouvrant le trou (130) traversant à découvert précédemment de la puce (100) barrière environnementale.

2. Un procédé de production d'une puce (100) barrière environnementale comprenant une membrane (110) barrière environnementale micro-structurée perméable à l'air, le procédé comprenant au moins les stades suivants :
se procurer un substrat (120) ayant une première surface (121) de substrat et une deuxième surface (122) opposée de substrat,
déposer une couche (150) sacrificielle sur au moins l'une des surfaces (121, 122) opposées de substrat,
structurer un trou (130) traversant dans le substrat (120), le trou traversant traversant complètement le substrat (120) entre les deux surfaces (121, 122) opposées du substrat, dans lequel la couche (150) sacrificielle reste et recouvre le trou (130) traversant,
déposer une ou plusieurs nanofibres (111) sur la couche (150) sacrificielle en appliquant au moins l'un d'un procédé d'électro-filage ou de filage par soufflage, de manière à ce que les nanofibres (111) filées se combinent en un réseau de nanofibres, qui forment une membrane (110) nanofibreuse, et
retirer la couche (150) sacrificielle pour libérer la membrane (110) nanofibreuse, dans lequel la membrane (110) nanofibreuse libérée forme une membrane (110) nanofibreuse autonome et se conformant mécaniquement recouvrant le trou (130) traversant.

3. Le procédé suivant la revendication 2,
dans lequel le stade de dépôt de la couche (150) sacrificielle comprend déposer une couche d'oxyde de silicium, et
dans lequel le stade d'enlèvement de la couche (150) sacrificielle est effectué en appliquant une opération d'attaque chimique en voie humide.

4. Le procédé suivant la revendication 3,
dans lequel le stade de dépôt de nanofibres (111) comprend déposer des nanofibres (111) comprenant ou faites d'un matériau résistant à un agent d'attaque utilisé dans le processus d'attaque chimique en voie humide.

5. Le procédé suivant la revendication 2,
dans lequel le stade d'enlèvement de la couche (150) sacrificielle est effectué en appliquant une opération de combustion à haute température.

6. Le procédé suivant la revendication 5,
dans lequel le stade de dépôt de la couche (150) sacrificielle comprend déposer une couche (150) sacrificielle comprenant ou faite d'un matériau à base de carbone pouvant être enlevé par l'opération de combustion à haute température.

7. Le procédé suivant la revendication 5 ou 6,
dans lequel le stade de dépôt des nanofibres (111) comprend déposer des nanofibres (111) comprenant ou faites d'au moins une matière polymère stable à haute température ou d'une matière à base de céramique ou d'une matière en oxyde métallique pour résister à l'opération de combustion à haute température.

8. Le procédé suivant la revendication 1 ou 2,
comprenant en outre un stade dans lequel on prévoit une structure (170) micro-structurée de support à l'intérieur du trou (130) traversant, la structure (170) de support étant suspendue au moyen de poutres (173) pouvant se rompre,
dans lequel le stade de dépôt des nanofibres (111) comprend déposer les nanofibres (111) sur la structure (170) de support, et
dans lequel le procédé comprend en outre un stade de rupture des poutres (173) pouvant se rompre et d'enlèvement de la structure (170) de support du trou (130) traversant pour libérer la membrane (110) nanofibreuse faite des nanofibres (111) déposées.

9. Le procédé suivant l'une quelconque des revendications précédentes,
comprenant en outre un stade de dépôt d'une couche favorisant l'adhérence sur au moins l'une des deux surfaces (121, 122) opposées du substrat,
dans lequel le stade de dépôt des nanofibres (111) comprend déposer des nanofibres (111) sur la couche favorisant l'adhérence.

10. Le procédé suivant l'une quelconque des revendications précédentes,
le procédé étant effectué au niveau de plaquette,
dans lequel le substrat (120) est prévu sous la forme d'une plaquette composant une pluralité desdits trous (130) traversants, et
dans lequel le stade de dépôt des nanofibres (111) comprend déposer les nanofibres (111) sur la au moins une des deux surfaces (121, 122) opposées du substrat de la plaquette (120) pour recouvrir ladite pluralité de trous (130) traversants dans la plaquette (120).

11. Le procédé suivant l'une quelconque des revendications 1 à 9,
le procédé étant effectué au niveau d'une puce,
dans lequel le substrat (120) est prévu sous la forme d'une seule puce ayant un seul trou (130) traversant, et
dans lequel le stade de dépôt de nanofibres (111) comprend déposer les nanofibres (111) sur les au moins deux surfaces (121, 122) opposées du substrat de la seule puce (120) pour recouvrir ledit seul trou (130) traversant dans la puce (120).

12. Le procédé suivant l'une quelconque des revendications précédentes,
comprenant en outre un stade de post-traitement des nanofibres (111) filées en appliquant une vaporisation de solvant et/ou un traitement thermique pour créer des nanofibres (111) réticulées.

13. Le procédé suivant l'une quelconque des revendications précédentes,
dans lequel le stade de dépôt des nanofibres (111) comprend déposer des nanofibres (111) comprenant des matières différentes et/ou de diamètres différents les unes des autres.

14. Une puce (100) barrière environnementale ayant une membrane (110) barrière environnementale perméable à l'air, la puce (100) barrière environnementale comprenant :
un substrat (120) comprenant un trou (130) traversant traversant entièrement deux surfaces (121, 122) opposées du substrat (120),
dans lequel une membrane (110) nanofibreuse autonome et se conformant mécaniquement est disposée sur au moins l'une des deux surfaces (121, 122) opposées du substrat (120), de manière à ce que la membrane (110) nanofibreuse recouvre le trou (130) traversant,
dans lequel la membrane (110) nanofibreuse est formée d'un réseau de nanofibres (111) filées disposées sur la au moins l'une des deux surfaces (121, 122) opposées du substrat (120).
